# EUROPEAN PATENT SPECIFICATION

(11) **EP 4 287 786 B1**
(45) Date of publication and mention of the grant of the patent: **27.08.2025**
(21) Application number: 22745697.7
(22) Date of filing: 20.01.2022
(51) Int. Cl.: H05K 1/02, H01M 10/44, H05K 3/46, H01M 10/42

(54) **POWER SUPPLY DEVICE**
STROMVERSORGUNGSVORRICHTUNG
DISPOSITIF D'ALIMENTATION ÉLECTRIQUE

(30) Priority: 27.01.2021 JP 2021011501
(43) Date of publication of application: 06.12.2023
(73) Proprietor: Panasonic Energy Co., Ltd., Osaka 570-8511 (JP)
(72) Inventor: KAWAI, Naoki, Kadoma-shi, Osaka 571-0057 (JP); YAMASHITA, Takahiro, Kadoma-shi, Osaka 571-0057 (JP)
(74) Representative: Novagraaf International SA
(86) International application number: PCT/JP2022/001891
(87) International publication number: WO 2022/163476

(56) References cited:
- WO-A1-2018/047407
- WO-A1-2020/219888
- CN-U- 211 406 678
- JP-A- 2002 289 990
- JP-A- 2014 064 127
- JP-A- 2014 170 835
- JP-A- 2020 018 055
- JP-B2- 6 699 535
- US-B2- 10 537 016

## Description

### TECHNICAL FIELD

The present invention relates to a power supply device.

### BACKGROUND ART

Power supply devices including a number of secondary battery cells which are connected in series and in parallel are used as backup power sources for servers, home-, office- or factory-use power supply devices used as stationary power storage batteries, power sources for driving vehicles such, for example, as hybrid vehicles, electric vehicles, electric carts or electric scooters, and power sources for driving electric power-assisted bicycles or electric power tools. These power supply devices including a number of secondary battery cells connected in series and parallel pursue high capacity and high output power.

The power supply device with a number of secondary battery cells includes power semiconductor elements. such as charging/discharging field effect transistors (FETs). which are mounted on a circuit board to charge and discharge the secondary battery cells. A battery module including secondary battery cells connected in series and parallel often includes field effect transistors connected in parallel for controlling the high current charging and discharging to reduce a load on each transistor, as disclosed in, e.g., PTL 1.

In such circuit board, however, the high current input and output ports are often gathered in one place by using, for example, a terminal block due to structural restrictions of the module. Further, the arrangement of the FETs and wiring patterns on the circuit board is often designed under the structural restrictions. In this case, the FETs are arranged such that current is likely to concentrate on parts of the FETs may provide a problem that the current is unevenly distributed to the parts of the FETs and exceeds the current rating of elements, resulting in thermal destruction of the element.

### Citation List

### Patent Literature

PTL 1: Japanese Patent Laid-Open Publication No. 2007-166715
PTL 2: Japanese Patent No. JP 6 699535 B2
PTL 3: Chinese Utility Model Patent No. CN 211 406 678 U
PTL 4: United States Patent No. US 10 537 016 B2
PTL 5: International Patent Application No. WO 2020/219888 A1

PTL2, PTL3 and PTL5 disclose circuits and circuit boards comprising a plurality of secondary battery cells and power semiconductor elements which are mounted on these circuit boards to charge and discharge the secondary battery cells. PTL4 discloses devices which use thermal vias to increase the current carrying capacity of conductive traces in a circuit board.

### SUMMARY OF THE INVENTION

### PROBLEM TO BE SOLVED

An object of the present invention is to provide a power supply device suppressing uneven distribution of current even if semiconductor elements are mounted in a limited area on a circuit board.

### SOLUTION TO PROBLEM

The invention is defined by the independent claim. Preferred embodiments are defined in the dependent claims.

A power supply device in the present invention includes secondary battery cells, semiconductor elements connected to the secondary battery cells, and a circuit board on which the semiconductor elements are mounted. The circuit board includes a first terminal block and a second terminal block located away from the first terminal block. The first terminal block electrically connects the semiconductor elements to the secondary battery cells. The semiconductor elements include a first semiconductor element and a third semiconductor element that are disposed at a side of
the first terminal block, and a second semiconductor element and a fourth semiconductor element that are disposed at a side of the second terminal block. The first semiconductor element and the second semiconductor element are connected parallel to the third semiconductor element and the fourth semiconductor element. The first semiconductor element and the second semiconductor element are connected in series to each other. A first current path connecting the first semiconductor element and the second semiconductor element in series to each other is longer than a second current path connecting the third semiconductor element and the fourth semiconductor element in series to each other. The first current path includes a first current impeding region, disposed between the first semiconductor element and the second semiconductor element, configured to impede current flow. The second current path includes a second current impeding region, disposed between the third semiconductor element and the fourth semiconductor element, configured to impede current flow. A second electrical resistance of the second current impeding region is higher than a first electrical resistance of the first current impeding region.

### ADVANTAGEOUS EFFECTS OF THE INVENTION

In the power supply device of the present invention, the second current impeding region allowing current to flow more hardly is provided in the second current path which is shorter than the first current path and which allows current to flow more easily than the first current path. This configuration suppresses concentration of current and prevents the second semiconductor element and the fourth semiconductor element from being excessively heated, so that the semiconductor elements may be uniformly heated.

### BRIEF DESCRIPTION OF DRAWINGS

FIG. 1 is a circuit diagram of a power supply device according to Exemplary Embodiment 1 of the present invention.
FIG. 2A is a plan view of a circuit board of the power supply device shown in FIG. 1.
FIG. 2B is a plan view of a circuit board of the power supply device in a modified example.
FIG. 3 is a plan view of a circuit board of the power supply device shown in FIG. 1.
FIG. 4 is a plan view of a circuit board according to Exemplary Embodiment 2 of the present invention.
FIG. 5 is a plan view of a circuit board according to Exemplary Embodiment 3 of the present invention.
FIG. 6 is a plan view showing a circuit board according to Exemplary Embodiment 4 of the present invention.

### DESCRIPTION OF EMBODIMENTS

Exemplary embodiments of the present invention may also be described based on the following configurations.

In a power supply device according to an embodiment of the present invention, in addition to the above-described structure, the first current impeding region and the second current impeding region may include thermal vias passing through the circuit board. The number of the thermal vias of the second current impeding region is larger than the number of the thermal vias of the first current impeding region.

In a power supply device according to another embodiment of the present invention, in addition to any of the above-described structures, the semiconductor elements further may include: a fifth semiconductor element disposed at a side of the first terminal block; and a sixth semiconductor element disposed at a side of the second terminal block. The fifth semiconductor element may be connected in parallel to the first semiconductor element. The sixth semiconductor element may be connected in parallel to the second semiconductor element. A third current path connecting the fifth semiconductor element and the sixth semiconductor element in series to each other may be longer than the second current path. The third current path may include a third current impeding region configured to impede current flow. A third resistance of the third current impeding region may be equal to the first electrical resistance of the first current impeding region.

In a power supply device according to still another embodiment of the present invention, in addition to any of the above-described structures, the third current impeding region includes thermal vias passing through the circuit board. The number of the thermal vias of the third current impeding region may be equal to the number of the thermal vias of in the first current impeding region.

In a power supply device according to a further embodiment of the present invention, in addition to any of the above-described structures, the semiconductor elements further may include: a seventh semiconductor element disposed at a side of the first terminal block; and an eighth semiconductor element disposed at a side of the second terminal block. The seventh semiconductor element may be connected in parallel to the first semiconductor element. The eighth semiconductor element may be connected in parallel to the second semiconductor element. A fourth current path connecting the seventh semiconductor element and the eighth semiconductor element in series to each other may be equal in length to the second current path. The fourth current path may include a fourth current impeding region configured to impede current flow. A fourth electrical resistance of the fourth current impeding region may be equal to the second electrical resistance of the second current impeding region.

In a power supply device according to a further embodiment of the present invention, in addition to any of the above-described structures, the fourth current impeding region may include thermal vias passing through the circuit board. The number of the thermal vias of the fourth current impeding region may be equal to the number of the thermal vias of the second current impeding region.

In a power supply device according to a further embodiment of the present invention, in addition to any of the above-described structures, the first current impeding region and the second current impeding region may include thermal vias passing through the circuit board. Electrical resistances of the first current impeding region and the second current impeding region may be determined based on areas of openings of the thermal vias.

In a power supply device according to a further aspect of the present invention, in addition to any of the above-described structures, the first semiconductor element and the third semiconductor element may be disposed closely to each other. The second semiconductor element and the fourth semiconductor element may be disposed closely to each other.

In a power supply device according to a further embodiment of the present invention, in addition to any of the above-described structures, the first terminal block and the second terminal block are through-holes.

In a power supply device according to a further embodiment of the present invention, in addition to any of the above-described structures, the semiconductor elements are field effect transistors.

In a power supply device according to a further embodiment of the present invention, in addition to any of the above-described structures, a source terminal of one field effect transistor out of field effect transistors constituting the first semiconductor element and the third semiconductor element may be closer to the first terminal block than a source terminal of another effect transistor out of the field effect transistors. The one field effect transistor may be closer to the first terminal block than the another effect transistor.

In a power supply device according to a further embodiment of the present invention, in addition to any of the above-described structures, a source terminal of one field effect transistor out of field effect transistors constituting the second semiconductor element and the fourth semiconductor element may be closer to the second terminal block than a source terminal of another effect transistor out of the field effect transistors. The one field effect transistor may be closer to the second terminal block than the another effect transistor.

Hereinafter, exemplary embodiments of the present invention will be described based on the drawings. However, the exemplary embodiments shown hereinafter are examples for embodying the technical ideas of the present invention. Particularly, the dimensions, materials, shapes, and relative positions of the structural members written in the exemplary embodiments are merely explanation examples. The sizes and positional relations of the members shown in each figure are sometimes exaggerated to clarify the explanation. Further, in the following description, like names or like reference marks indicate like or identical members, and detailed explanation on them will appropriately be omitted. Further, each component constituting the present invention may be, in one aspect, such that plural components are configured using a same member to use a single member commonly as plural components, or may be, in another aspect on the contrary, such that plural members share implementation of one function of one member. Also, some contents described in a part of working examples or exemplary embodiments may be applicable to other examples or exemplary embodiments.

Also, the term "equal to" used in the present specification means not only exactly the same, but also approximately the same containing some margin of error.

Power supply devices according to exemplary embodiments may be used for various uses including, for example, backup power sources for servers, power sources equipped in electric-powered vehicles such, for example, as hybrid vehicles and electric vehicles to supply power to the driving motor, power sources for storing natural energy power generated by the solar power generation and wind-powered electricity generation, or power sources for storing the midnight electric power. Especially, power supply devices according to the exemplary embodiments may be used as power sources suitable to high-power, high-current uses. In the following examples, description will be made on a power supply device used as a backup power source for a server.

### Exemplary Embodiment 1

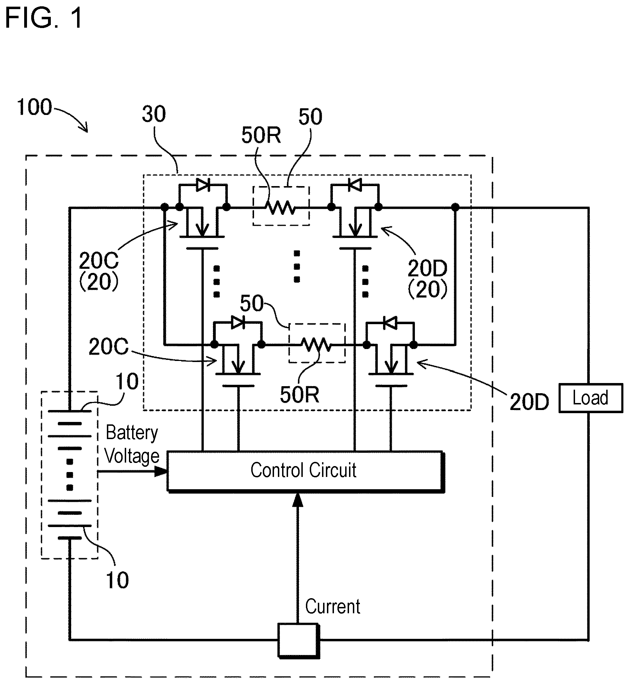

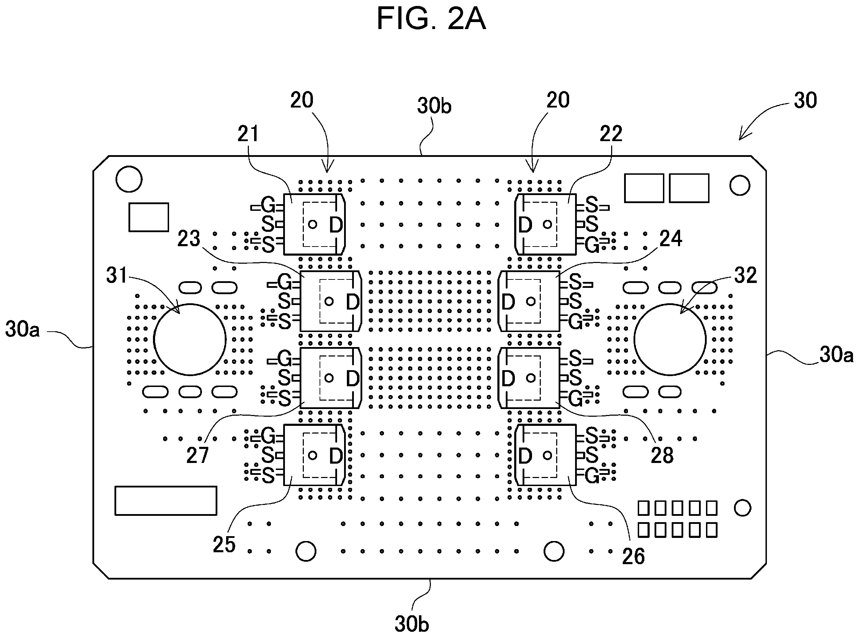

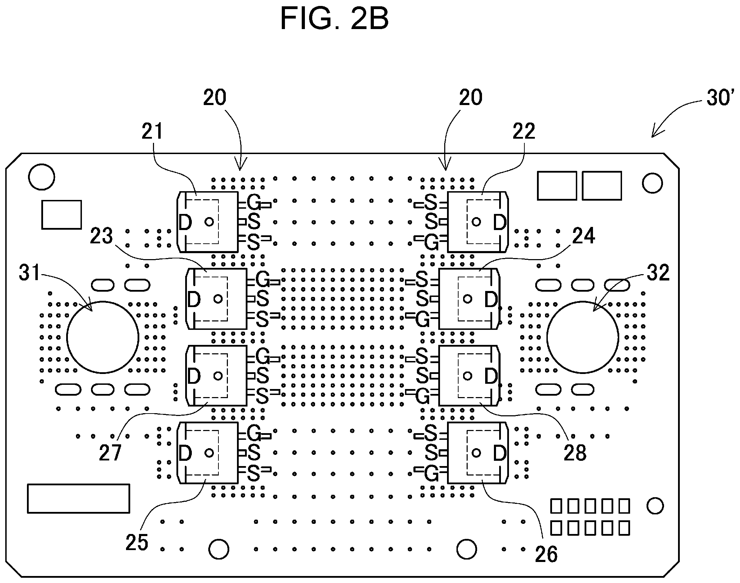

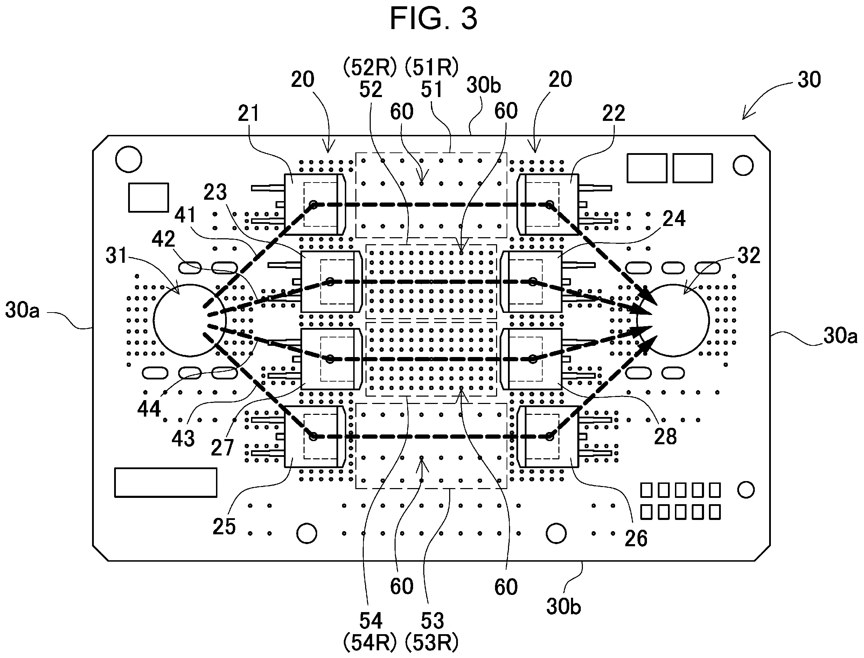

Power supply device 100 according to Exemplary Embodiment 1 of the present invention is shown in FIGS. 1 to 3. FIG. 1 is a circuit diagram of the power supply device according to Embodiment 1 of the present invention. FIG. 2A is a plan view of a circuit board of the power supply device shown in FIG. 1. FIG. 2B is a plan view of a circuit board in a modified example of the power supply device. FIG. 3 is a plan view of a circuit board of the power supply device shown in FIG. 1.

### Power Supply Device 100

Power supply device 100 shown in the circuit diagram of FIG. 1 includes secondary battery cells 10, charging/discharging field effect transistors (FETs) 20 which are semiconductor elements connected to secondary battery cells 10, and circuit board 30 on which charging/discharging FETs 20 are mounted. Charging/discharging FETs 20 include charging FETs 20C for charging the secondary battery cells, and discharging FETs 20D for discharging the secondary battery cells. Charging FETs 20C and discharging FETs 20D may be arranged in consideration of the withstanding voltage and the rating voltage such that the elements are connected in series or in parallel or in series-parallel to disperse the load put on each element. Here, charging FETs 20C are connected in parallel to one another and plural discharging FETs 20D are connected in parallel to one another to reduce the amount of current flown in each FET.

Charging FETs 20C connected in parallel to one another and discharging FETs connected in parallel to one another are connected in series to one another through current impeding regions 50 provided between the parallelly connected charging FETs 20C and the parallelly connected discharging FETs 20D. Each current impeding region 50 has a predetermined electrical resistance. The electrical resistances of current impeding regions 50 are virtually indicated by electrical resistors 50R in the equivalent circuit shown in FIG. 1, no physical resistors are actually mounted.

Power supply device 100 according to the present exemplary embodiment is often configured under structural restrictions on the arrangement of charging/discharging FETs 20 mounted on circuit board 30 and circuit patterns of circuit board 30 to control the charging and discharging with high current. In this condition, such an arrangement that causes concentration of current on a part of charging/discharging FETs 20 may cause uneven distribution of current during charging or discharging, and excessively heat the part of charging/discharging FETs 20. Current impeding region 50 in each current path of circuit board 30 and adjusting the resistance of current impeding region 50, or adjusting the virtual electrical resistance 50R to increase the electrical resistance of a region on which current tends to concentrate, thereby suppressing the uneven distribution of current.

### Secondary Battery Cell 10

The secondary battery cells 10 are at least connected in series. A set of secondary battery cells 10 connected in series to one another may be connected in parallel to another set of secondary battery cells 10 connected in series to one another. An output of such a battery assembly that are constructed by secondary battery cells 10 containing series-connected secondary battery cells is obtained as an output from power supply device 100. Battery cells used as secondary battery cells 10 may be chargeable batteries such as lithium-ion batteries or nickel hydride batteries.

### Charging/Discharging FET 20

Charging/discharging FETs 20 are configured to control charging or discharging of secondary battery cells 10. The FET used as charging/discharging FET 20 may be any existing FET such as MOSFET. FIG. 2A shows an aspect of charging/discharging FETs 20. Each charging/discharging FET 20 shown in FIG. 2A is a surface mount MOSFET having two source terminals S and one gate terminal G at one end thereof and having a tab-shaped drain terminal D at the other end thereof. However, the charging/discharging FET in accordance with the present exemplary embodiment may have any number of terminals, any arrangement of terminals and any package structure. For example, the charging/discharging FET may have seven terminals at one end thereof.

The number of charging/discharging FETs 20 may be appropriately determined depending on the circuit board on which they are mounted. In the present exemplary embodiment, for example, first charging/discharging FET 21 to eighth charging/discharging FET 28 are mounted as charging/discharging FETs 20 on circuit board 30, which will be described later. In this example, each of first charging/discharging FET 21, third charging/discharging FET 23, fifth charging/discharging FET 25 and seventh charging/discharging FET 27 corresponds to the charging FET. Each of second charging/discharging FET 22, fourth charging/discharging FET 24, sixth charging/discharging FET 26 and eighth charging/discharging FET 28 corresponds to the discharging FET.

### Circuit Board 30

Circuit board 30 shown in FIG. 2A includes first terminal block 31 that electrically connects the charging/discharging FETs 20 to the secondary battery cells 10 and includes second terminal block 32 located away from first terminal block 31. Any existing circuit board may be used as circuit board 30. In the present exemplary embodiment, a multi-layer board having six layers is used as circuit board 30. However, circuit board 30 may not be limited to the six-layer board, and may be a circuit board having five or less layers or a circuit board having seven or more layers. The thickness of each layer may be, for example, about 70 µm, but may appropriately be determined.

Circuit board 30 may have any shape. In the present exemplary embodiment, circuit board 30 substantially has a rectangular shape having short sides 30a and long sides 30b in plan view. As an example, short side 30a may have a length of about 6 cm and long side 30b may have a length of about 10 cm. However, the sizes of short sides 30a and long sides 30b may be appropriately determined depending on the components mounted on circuit board 30.

### First Terminal Block 31 and Second Terminal Block 32

First terminal block 31 and second terminal block 32 are configured to input and output currents. FIG. 2A shows examples of first terminal block 31 and second terminal block 32. As shown in FIG. 2A, first terminal block 31 and second terminal block 32 are through-holes located close to two short sides 30a of circuit board 30 away from each other, respectively. A conductive pattern is formed around each through-hole as a connecting area of a terminal. First terminal block 31 and second terminal block 32 function as current input and output ports that allow large amount of current to flow over the entire surface of circuit board 30 from the first terminal block 31 to the second terminal block 32 or from the second terminal block 32 to the first terminal block 31 on circuit board 30.

First charging/discharging FET 21 and third charging/discharging FET 23 are disposed at a side of the first terminal block 31 on circuit board 30, and second charging/discharging FET 22 and fourth charging/discharging FET 24 are disposed at a side of the second terminal block 32 on circuit board 30. The number of charging/discharging FETs 20 may be appropriately adjusted depending on the size of the circuit board. Accordingly, in the present exemplary embodiment, fifth charging/discharging FET 25 and seventh charging/discharging FET 27 are additionally disposed at a side of the first terminal block 31 on circuit board 30, and sixth charging/discharging FET 26 and eighth charging/discharging FET 28 are additionally disposed at a side of the second terminal block 32 on circuit board 30.

As an example, first charging/discharging FET 21, third charging/discharging FET 23, seventh charging/discharging FET 27, and fifth charging/discharging FET 25 are disposed at a side of the first terminal block 31 between first terminal block 31 and second terminal block 32 while deviating in a direction substantially along short side 30a of circuit board 30. First charging/discharging FET 21 and fifth charging/discharging FET 25 are disposed near the two long sides 30b of circuit board 30, respectively. Third charging/discharging FET 23 and seventh charging/discharging FET 27 are disposed between first charging/discharging FET 21 and fifth charging/discharging FET 25. In this example, third charging/discharging FET 23 is disposed at the side closer to first charging/discharging FET 21, and seventh charging/discharging FET 27 is disposed at the side closer to fifth charging/discharging FET 25.

First charging/discharging FET 21, third charging/discharging FET 23, seventh charging/discharging FET 27, and fifth charging/discharging FET 25 are disposed closely to one another. The FETs may be arranged in a direction to align on a straight line or may be arranged with an offset. For example, some charging/discharging FETs out of first charging/discharging FET 21, third charging/discharging FET 23, seventh charging/discharging FET 27 and fifth charging/discharging FET 25, having source terminals S closer to first terminal block 31 than other charging/discharging FETs may be disposed closer to first terminal block 31 than the other charging/discharging FETs.

In other words, first charging/discharging FET 21 and fifth charging/discharging FET 25 may be disposed closer to first terminal block 31 than third charging/discharging FET 23 and seventh charging/discharging FET 27. In this arrangement, the distance from each of the respective source terminals S of first charging/discharging FET 21 and fifth charging/discharging FET 25, which are located far apart from first terminal block 31, to first terminal block 31 may be reduced compared to the arrangement in which the charging/discharging FETs are disposed on a straight line. This configuration allows current to easily flow from first terminal block 31 to source terminals S of first charging/discharging FET 21 and fifth charging/discharging FET 25.

At a side of the second terminal block 32 on circuit board 30, second charging/discharging FET 22 is disposed at a position facing first charging/discharging FET 21, fourth charging/discharging FET 24 is disposed at a position facing third charging/discharging FET 23, sixth charging/discharging FET 26 is disposed at a position facing fifth charging/discharging FET 25, and eighth charging/discharging FET 28 is disposed at a position facing seventh charging/discharging FET 27.

Similarly to the first terminal block 31 side, second charging/discharging FET 22, fourth charging/discharging FET 24, eighth charging/discharging FET 28, and sixth charging/discharging FET 26 are disposed closely to one another. The FETs may be arranged in a direction to align on a straight line or may be arranged with an offset. Further, some charging/discharging FETs out of second charging/discharging FET 22, fourth charging/discharging FET 24, eighth charging/discharging FET 28 and sixth charging/discharging FET 26, having source terminals S closer to second terminal block 32 than other charging/discharging FETs may be disposed closer to second terminal block 32 than the other charging/discharging FETs.

On the other hand, as shown in FIG. 2A, the four charging/discharging FETs 21, 23, 27 and 25 at a side of the first terminal block 31 on circuit board 30 are apart from the four charging/discharging FETs 22, 24, 28 and 26 at a side of the second terminal block 32 on circuit board 30, respectively. In a circuit board having the structure in which input and output ports are gathered in one location by using, for example, the terminal blocks like circuit board 30, a large amount of heat may be generated at drain terminals D of charging/discharging FETs 21 to 28. In this case, if charging/discharging FETs 21 to 28 are arranged such that their drain terminals are disposed to be close to one another on the central portion of the circuit board, a part of the circuit board may be excessively heated locally. Considering this concern, according to the present exemplary embodiment, some of charging/discharging FETs 21 to 28 are disposed closely to first terminal block 31 and the others are disposed closely to second terminal block 32 so that the FETs are located apart from each other to avoid concentration of heat and to secure safety.

Regarding the connection of charging/discharging FETs 21 to 28, first charging/discharging FET 21, third charging/discharging FET 23, fifth charging/discharging FET 25, and seventh charging/discharging FET 27, which are disposed at the first terminal block 31 side on circuit board 30, are connected in parallel to one another. Similarly, second charging/discharging FET 22, fourth charging/discharging FET 24, sixth charging/discharging FET 26, and eighth charging/discharging FET 28, which are disposed at the second terminal block 32 side on circuit board 30, are connected in parallel to one another. Further, first charging/discharging FET 21 is connected in series to second charging/discharging FET 22, third charging/discharging FET 23 is connected in series to fourth charging/discharging FET 24, fifth charging/discharging FET 25 is connected in series to sixth charging/discharging FET 26, and seventh charging/discharging FET 27 is connected in series to eighth charging/discharging FET 28.

### Modified Embodiment

In the example described above in the present exemplary embodiment, charging/discharging FETs 21 to 28 are arranged such that their drain terminals face each other in planar view. However, the arrangement of the charging/discharging FETs according to the present exemplary embodiment may not be limited to the above-described embodiment. For example, the positions of charging FETs 20C and the positions of discharging FETs 20D may be reversed to each other. A circuit diagram of such example is shown in FIG. 2B as a power supply device according to a modified embodiment. On circuit board 30' shown in FIG. 2B, charging/discharging FETs 21 to 28 are arranged such that their source terminals face each other in planar view.

### First Current Path 41 to Fourth Current Path 44

Each of first current path 41 to fourth current path 44 includes a charging/discharging FET ta aside of the first terminal block 31 on circuit board 30 and a charging/discharging FET at a side of the second terminal block 32 on circuit board 30 which are connected in series to each other as shown in FIG. 3. Specifically, first current path 41 includes first charging/discharging FET 21 and second charging/discharging FET 22. Similarly, second current path 42 includes third charging/discharging FET 23 and fourth charging/discharging FET 24. Third current path 43 includes fifth charging/discharging FET 25 and sixth charging/discharging FET 26. Fourth current path 44 includes seventh charging/discharging FET 27 and eighth charging/discharging FET 28. Currents flow along first current path 41 to fourth current path 44 from the first terminal block 31 to the second terminal block 32 or from the second terminal block 32 to the first terminal block 31 on circuit board 30. Although such an example that currents flow from the first terminal block 31 to the second terminal block 32 on circuit board 30 will be explained in the present exemplary embodiment, the current flowing direction may not be limited to this embodiment.

Regarding the positional relations of first current path 41 to fourth current path 44, first current path 41 and third current path 43 are disposed close to two long sides 30b of circuit board 30, respectively. Second current path 42 and fourth current path 44 are disposed between first current path 41 and third current path 43. In other words, first current path 41 and third current path 43 are located farther away from first terminal block 31 and second terminal block 32 than second current path 42 and fourth current path 44. This arrangement allows first current path 41 and third current path 43 to have the same length and longer than second current path 42. Fourth current path 44 has the same length as second current path 42.

In the structure in which terminal blocks are provided at locations respectively close to both short sides 30a of circuit board 30 and FETs are disposed closely to each of the terminal blocks as shown in FIG. 3, there is a problem that an uneven distribution of current is likely to occur since current tends to more easily flow in the shortest current path between the input and output ports or in a current path having a lower resistance. Accordingly, current flows easily in second current path 42 and fourth current path 44 which are the shortest current paths and hardly flows in first current path 41 and third current path 43. In other words, currents tend to concentrate on third charging/discharging FET 23 and fourth charging/discharging FET 24 which are disposed on second current path 42 and on seventh charging/discharging FET 27 and eighth charging/discharging FET 28 which are disposed on fourth current path 44. As a result, currents are unevenly distributed to a part of the charging/discharging FETs during charging or discharging to exceed the current rating of the charging/discharging FET, which would possibly cause a thermal destruction of the charging/discharging FET. Considering this concern, according to the present exemplary embodiment, later-described current impeding regions 50 are provided to suppress the uneven distribution of current.

### First Current Impeding Region 51 to Fourth Current Impeding Region 54

Each of current impeding regions 50 is configured to impede the flow of current by electrical resistance 50R indicating the resistance of the region. The number and sizes of current impeding regions 50 may be appropriately determined. In the present exemplary embodiments, first current impeding region 41 to fourth current impeding region 54 constitute current impeding regions 50. As shown in FIG. 3, first current path 41 includes first current impeding region 51 having first electrical resistance 51R. Similarly, second current path 42 includes second current impeding region 52 having second electrical resistance 52R. Third current path 43 includes third current impeding region 53 having third electrical resistance 53R. Fourth current path 44 includes fourth current impeding region 54 having fourth electrical resistance 54R. First electrical resistance 51R to fourth electrical resistance 54R are determined such that second electrical resistance 52R of second current impeding region 52 is higher than first electrical resistance 51R of first current impeding region 51. Third electrical resistance 53R of third current impeding region 53 is equal to first electrical resistance 51R. Further, fourth electrical resistance 54R of fourth current impeding region 54 is equal to second electrical resistance 52R.

In other words, each of second electrical resistance 52R of second current impeding region 52 and fourth electrical resistance 54R of fourth current impeding region 54 is higher than each of first electrical resistance 51R of first current impeding region 51 and third electrical resistance 53R of third current impeding region 53. This configuration allows currents to more easily flow in first current path 41 and third current path 43, which are the lower electrical resistance paths. As a result, although currents otherwise hardly flow in first current path 41 and third current path 43, more amounts of currents flow in first charging/discharging FET 21 and second charging/discharging FET 22 on first current path 41 and in fifth charging/discharging FET 25 and sixth charging/discharging FET 26 on third current path 43, thus suppressing the uneven distribution of current. Further, since the current concentration is suppressed, third charging/discharging FET 23, fourth charging/discharging FET 24, seventh charging/discharging FET 27 and eighth charging/discharging FET 28 are prevented from being excessively heated, thus suppressing the uneven heat generation so that heat generated at each charging/discharging FET becomes uniformly small.

### Thermal Vias 60

To adjust first electrical resistance 51R to fourth electrical resistance 54R as described above, any arbitrary method may be used, including a method to change the width, thickness, or material of the conductive pattern in each current impeding region. In the present exemplary embodiment, an example of thermal vias 60 will be explained. FIG. 3 shows thermal vias 60 according to the embodiment. As shown in FIG. 3, thermal vias 60 are through-holes provided in circuit board 30. Thermal vias 60 may be formed by any existing method. In the present exemplary embodiment, for example, thermal vias 60 are formed by boring with a drill. In this manner, thermal vias 60 can be formed by a simple method. The diameter of each hole may range from 0.3 mm to 0.5 mm, but may be appropriately adjusted depending, for example, on the size of the circuit board or the arrangement of the charging/discharging FETs.

The number of thermal vias 60 in second current impeding region 52 is larger than the number of thermal vias 60 in first current impeding region 51. The increase of the number of thermal vias 60 in second current impeding region 52 may reduce the area of circuit board 30 in second current impeding region 52. In other words, the area of the region in which currents can flow is reduced, so that second electrical resistance 52R increases to cause currents to hardly flow in second current path 42.

Similarly, the number of thermal vias 60 in fourth current impeding region 54 is larger than the number of thermal vias 60 in third current impeding region 53. The increase of the number of thermal vias 60 in fourth current impeding region 54 may reduce the area of circuit board 30 in fourth current impeding region 54, so that fourth electrical resistance 54R may increase to cause currents to hardly flow in fourth current path 44. In this manner, the electrical resistance of each current path may be easily adjusted by the number of thermal vias 60 provided therein.

The number of thermal vias 60 may be appropriately determined depending on the size of the circuit board, the number and sizes of the mounted charging/discharging FETs, and the arrangement of the mounted components. In the present exemplary embodiment, for example, about 30 to 40 thermal vias 60 are formed in each of first current impeding region 51 and third current impeding region 53, and approximately 80 to 90 thermal vias 60 are formed in each of second current impeding region 52 and fourth current impeding region 54.

The thermal vias are usually used to improve the heat dissipation capability. In the present exemplary embodiment, however, a number of thermal vias are formed to increase the electrical resistance. In this manner, the electrical resistance may be adjusted by perforation, or by the simple machining, and such an advantageous effect can be obtained that the heat dissipation capability can be improved.

### Exemplary Embodiment 2

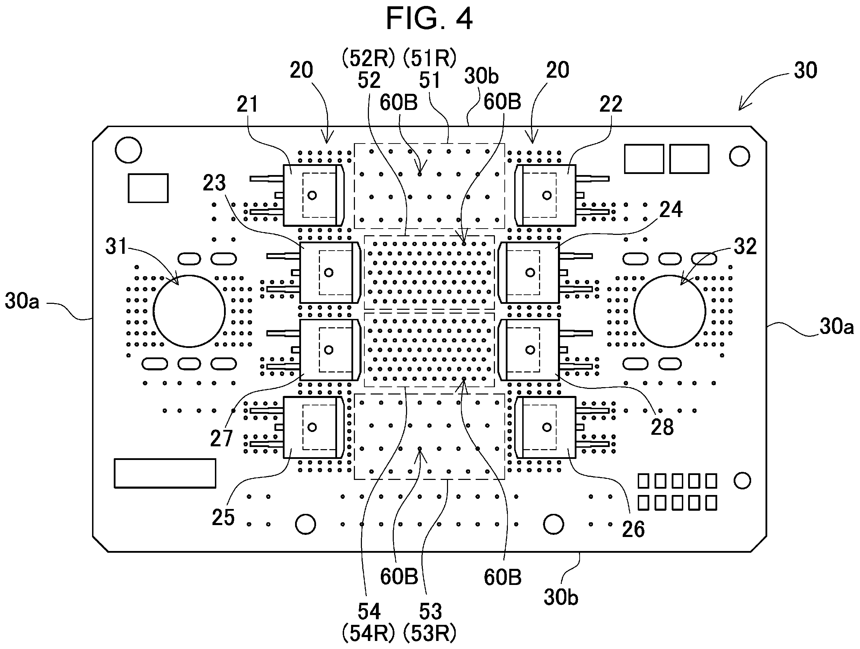

Thermal vias 60 in Embodiment 1 are formed to align in the vertical direction and in the lateral direction in planar view of FIG. 2A and FIG. 3, the thermal vias according to exemplary embodiments of the present invention may not be limited to the above-described embodiment. For example, thermal vias 60B according to the second exemplary embodiment are formed such that thermal vias 60B are arranged in an offset pattern as shown in FIG. 4. This arrangement forms thermal vias 60B uniformly over each entire current impeding region, so that the uneven distribution of current can be further suppressed.

### Exemplary Embodiment 3

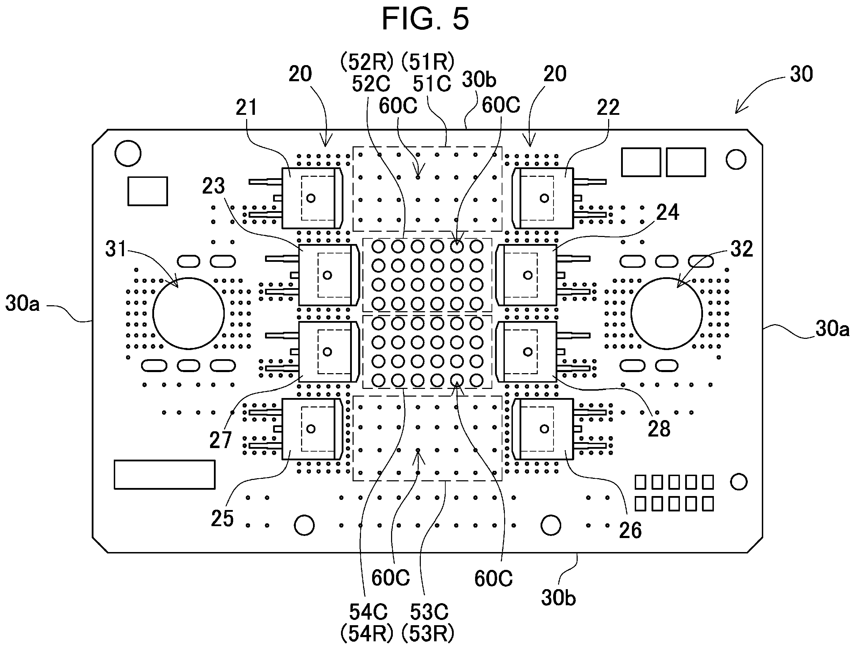

The hole diameters of thermal vias 60 in Embodiment 1 are approximately the same, the thermal vias of exemplary embodiments of the present invention may not be limited to the above-described embodiment. For example, the hole diameters of thermal vias 60C according to Exemplary Embodiment 3 are not the same as shown in FIG. 5. More specifically, the hole diameters of thermal vias 60C in second current impeding regions 52C and fourth current impeding region 54C are larger than the hole diameters of thermal vias 60C in first current impeding regions 51C and fourth current impeding region 53C. In other words, the area of circuit board 30 in each of second current impeding region 52C of second current path 42 and fourth current impeding region 54C of fourth current path 44, on which otherwise currents tend to concentrate, are smaller than the area of circuit board 30 in each of first current impeding region 51C and third current impeding region 53C.

The increase of second electrical resistance 52R and fourth electrical resistance 54R allows more amounts of currents to flow in first current path 41 and third current path 43 in which otherwise currents hardly flow, thus suppressing the uneven distribution of current. In other words, the electrical resistance of each current path may be easily adjected by adjusting the areas of the openings of thermal vias 60C. Further, in the third exemplary embodiment, since the electrical resistance may be increased by merely increasing the hole diameter of each thermal via, it is possible to save the steps of forming a number of thermal vias.

### Exemplary Embodiment 4

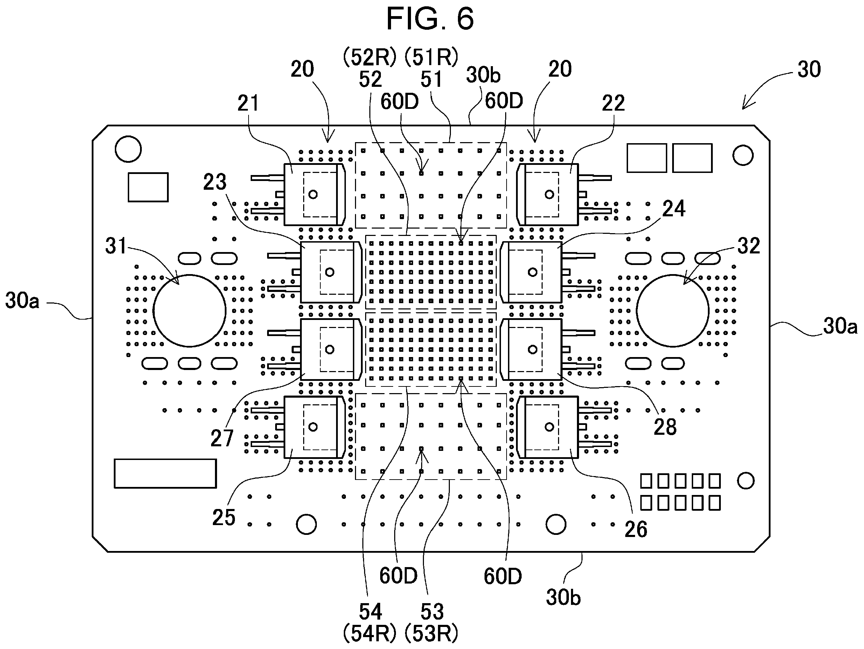

Thermal via 60 has substantially a circular shape in Embodiment 1, the thermal vias according to exemplary embodiments of the present invention may not be limited to the above-described shape. For example, the shape of each thermal via may be substantially a rectangular shape like thermal vias 60D according to Exemplary Embodiment 4 shown in FIG. 6.

### INDUSTRIAL APPLICABILITY

A power supply device according to the present invention can be preferably used as a backup power supply device that can be equipped in the power modules of the computer servers. Also, the power supply device according to the present invention can be appropriately used as a backup power supply device for the wireless base stations of the mobile phones, a home-use storage battery, an industrial-use storage battery, a power source for the street light, an electric storage device combined with the solar cells, a backup power source for the traffic signals, or a power source for the electric vehicles such, for example, as the plug-in hybrid electric automobiles each being switchable between an EV driving mode and an HEV driving mode, the hybrid electric automobiles, and other electric automobiles.

### REFERENCE MARKS IN THE DRAWINGS

100 power supply device
10 secondary battery cell 20 charging/discharging FET 20C charging FET 20D discharging FET 21 first charging/discharging FET 22 second charging/discharging FET 23 third charging/discharging FET 24 fourth charging/discharging FET 25 fifth charging/discharging FET 26 sixth charging/discharging FET 27 seventh charging/discharging FET 28 eighth charging/discharging FET 30, 30 circuit board 30a short side
   30b long side
31 first terminal block
32 second terminal block
41 first current path
42 second current path
43 third current path
44 fourth current path
50 current impeding region
50R electrical resistor
51, 51C first current impeding region
51R first electrical resistance
52, 52C second current impeding region
52R second electrical resistance
53, 53C third current impeding region
53R third electrical resistance
54, 54C fourth current impeding region
54R fourth electrical resistance
60, 60B, 60C, 60D thermal via

## Claims

1. A power supply device (100) comprising:
a plurality of secondary battery cells (10);
a plurality of semiconductor elements (20) connected to the plurality of secondary battery cells (10); and
a circuit board (30) on which the plurality of semiconductor elements (20) are mounted, the circuit board (30) including a first terminal block (31) and a second terminal block (32) located away from the first terminal block (31), the first terminal block (31) electrically connecting the plurality of semiconductor elements (20) to the plurality of secondary battery cells (10), wherein:
the plurality of semiconductor elements (20) include:
a first semiconductor element (21) and a third semiconductor element (23) that are disposed at a side of the first terminal block (31); and
a second semiconductor element (22) and a fourth semiconductor element (24) that are disposed at a side of the second terminal block (32),
the first semiconductor element (21) and the second semiconductor element (22) are connected parallel to the third semiconductor element (23) and the fourth semiconductor element (24),
the first semiconductor element (21) and the second semiconductor element (22) are connected in series to each other and constitute a first current path (41) extending from the first terminal block (31) to the second terminal block (32),
the third semiconductor element (23) and the fourth semiconductor element (24) are connected in series to each other and constitute a second current path (42) extending from the first terminal block (31) to the second terminal block (32),
the first current path (41) is connected parallel to the second current path (42) at the first terminal block (31) and the second terminal block (32),
first terminal block (31) and second terminal block (32) are current input and output ports, mounted on the circuit board (30) and configured to allow current flow from the first terminal block (31) to the second terminal block (32) or from the second terminal block (32) to the first terminal block (31) on the circuit board (30),
the first semiconductor element (21) and the third semiconductor element (23) that are disposed at a side of the first terminal block (31) on the circuit board (30) are apart from the second semiconductor element (22) and the fourth semiconductor element (24) that are disposed at a side of the second terminal block (32),
one of the first semiconductor element (21) and the third semiconductor element (23) is disposed closer to first terminal block (31) than the other, and one of the second semiconductor element (22) and the fourth semiconductor element (24) is disposed closer to second terminal block (32) than the other,
**characterized in that**
the first current path (41) is longer than the second current path (42),
the first current path (41) includes a first current impeding region (51 51C) disposed between the first semiconductor element (21) and the second semiconductor element (22), the first current impeding region (51 51C) being configured to impede current flow,
the second current path (42) includes a second current impeding region (52 52C) disposed between the third semiconductor element (23) and the fourth semiconductor element (24), the second current impeding region (52 52C) being configured to impede current flow, and
a second electrical resistance (52R) of the second current impeding region (52 52C) is higher than a first electrical resistance (51R) of the first current impeding region (51 51C).

2. The power supply device (100) according to claim 1, wherein
the first current impeding region (51 51C) and the second current impeding region (52 52C) include a plurality of thermal vias (60 60B 60C 60D), configured as through-holes provided in the printed circuit board (30) and passing through the circuit board (30), and
a number of the thermal vias (60 60B 60C 60D) of the second current impeding region (52 52C) is larger than a number of the thermal vias (60 60B 60C 60D) of the first current impeding region (51 51C).

3. The power supply device (100) according to claim 1 or 2, wherein
the plurality of semiconductor elements (20) further include:
a fifth semiconductor element (25) disposed at a side of the first terminal block (31); and
a sixth semiconductor element (26) disposed at a side of the second terminal block (32),
the fifth semiconductor element (25) and the sixth semiconductor element (26) are connected in parallel to the first semiconductor element (21) and the second semiconductor element (22),
the fifth semiconductor element (25) and the sixth semiconductor element (26) are connected in series to each other and constitute a third current path (43) extending from the first terminal block (31) to the second terminal block (32),
the third current path (43) is longer than the second current path (42),
the third current path (43) includes a third current impeding region (53 53C) configured to impede current flow, and
a third electrical resistance (53R) of the third current impeding region (53 53C) is equal to the first electrical resistance (51R) of the first current impeding region (51 51C).

4. The power supply device (100) according to claim 3, wherein
the third current impeding region (53 53C) includes a plurality of thermal vias (60 60B 60C 60D) passing through the circuit board (30), and
a number of the thermal vias (60 60B 60C 60D) of the third current impeding region (53 53C) is equal to the number of thermal vias (60 60B 60C 60D) of the first current impeding region (51 51C).

5. The power supply device (100) according to any of claims 1 to 4, wherein
the plurality of semiconductor elements (20) further include:
a seventh semiconductor element (27) disposed at a side of the first terminal block (31); and
an eighth semiconductor element (28) disposed at a side of the second terminal block (32),
the seventh semiconductor element (27) and the eighth semiconductor element (28) are connected in parallel to the first semiconductor element (21) and the second semiconductor element (22),
the seventh semiconductor element (27) and the eighth semiconductor element (28) are connected in series to each other and constitute a fourth current path (44) extending from the first terminal block (31) to the second terminal block (32),
the fourth current path (44) is equal in length to the second current path (42), the fourth current path (44) includes a fourth current impeding region (54 54C) configured to impede current flow, and
a fourth electrical resistance (54R) of the fourth current impeding region (54 54C) is equal to the second electrical resistance (52R) of the second current impeding region (52 52C).

6. The power supply device (100) according to claim 5, wherein
the fourth current impeding region (54 54C) includes a plurality of thermal vias (60 60B 60C 60D) passing through the circuit board (30), and
the number of the thermal vias (60 60B 60C 60D) of the fourth current impeding region (54 54C) is equal to the number of thermal vias (60 60B 60C 60D) of the second current impeding region (52 52C).

7. The power supply device (100) according to claim 1, wherein
the first current impeding region (51 51C) and the second current impeding region (52 52C) include a plurality of thermal vias (60 60B 60C 60D) passing through the circuit board (30), and
electrical resistances of the first current impeding region (51 51C) and the second current impeding region (52 52C) are determined based on areas of openings of the thermal vias (60 60B 60C 60D).

8. The power supply device (100) according to any of claims 1 to 7, wherein
the first semiconductor element (21) and the third semiconductor element (23) are disposed closely to each other, and
the second semiconductor element (22) and the fourth semiconductor element (24) are disposed closely to each other.

9. The power supply device (100) according to any of claims 1 to 8, wherein the first terminal block (31) and the second terminal block (32) are through-holes.

10. The power supply device (100) according to any of claims 1 to 9, wherein the plurality of semiconductor elements (20) are field effect transistors.

11. The power supply device (100) according to claim 10, wherein
a source terminal (S) of one field effect transistor out of field effect transistors constituting the first semiconductor element (21) and the third semiconductor element (23) is closer to the first terminal block (31) than a source terminal (S) of another effect transistor out of the field effect transistors, and
the one field effect transistor is closer to the first terminal block (31) than the another effect transistor.

12. The power supply device (100) according to claim 10, wherein
a source terminal (S) of one field effect transistor out of field effect transistors constituting the second semiconductor element (22) and the fourth semiconductor element (24) is closer to the second terminal block (32) than a source terminal (S) of another effect transistor out of the field effect transistors, and
the one field effect transistor is closer to the second terminal block (32) than the another effect transistor.

## Patentansprüche

1. Energieversorgungsvorrichtung (100), die Folgendes umfasst:
eine Vielzahl von Sekundärbatteriezellen (10);
eine Vielzahl von Halbleiterelementen (20), die mit der Vielzahl von Sekundärbatteriezellen (10) verbunden sind; und
eine Leiterplatte (30), auf der die Vielzahl von Halbleiterelementen (20) montiert sind, wobei die Leiterplatte (30) einen ersten Anschlussblock (31) und einen zweiten Anschlussblock (32), der sich vom ersten Anschlussblock (31) entfernt befindet, beinhaltet, wobei der erste Anschlussblock (31) die Vielzahl von Halbleiterelementen (20) mit der Vielzahl von Sekundärbatteriezellen (10) elektrisch verbindet, wobei:
die Vielzahl von Halbleiterelementen (20) Folgendes beinhalten:
ein erstes Halbleiterelement (21) und ein drittes Halbleiterelement (23), die auf einer Seite des ersten Anschlussblocks (31) angeordnet sind; und
ein zweites Halbleiterelement (22) und ein viertes Halbleiterelement (24), die auf einer Seite des zweiten Anschlussblocks (32) angeordnet sind,
wobei das erste Halbleiterelement (21) und das zweite Halbleiterelement (22) parallel zum dritten Halbleiterelement (23) und zum vierten Halbleiterelement (24) verbunden sind,
wobei das erste Halbleiterelement (21) und das zweite Halbleiterelement (22) in Reihe miteinander verbunden sind und einen ersten Strompfad (41) bilden, der sich vom ersten Anschlussblock (31) zum zweiten Anschlussblock (32) erstreckt,
wobei das dritte Halbleiterelement (23) und das vierte Halbleiterelement (24) in Reihe miteinander verbunden sind und einen zweiten Strompfad (42) bilden, der sich vom ersten Anschlussblock (31) zum zweiten Anschlussblock (32) erstreckt,
der erste Stromfahrt (41) parallel zum zweiten Strompfad (42) am ersten Anschlussblock (31) und am zweiten Anschlussblock (32) verbunden ist,
der erste Anschlussblock (31) und der zweite Anschlussblock (32) Stromeingangs- und -ausgangsports sind, die auf der Leiterplatte (30) montiert und dazu ausgelegt sind, einen Stromfluss vom ersten Anschlussblock (31) zum zweiten Anschlussblock (32) oder vom zweiten Anschlussblock (32) zum ersten Anschlussblock (31) auf der Leiterplatte (30) zu erlauben,
das erste Halbleiterelement (21) und das dritte Halbleiterelement (23), die auf einer Seite des ersten Anschlussblocks (31) auf der Leiterplatte (30) angeordnet sind, vom zweiten Halbleiterelement (22) und vom vierten Halbleiterelement (24), die auf einer Seite des zweiten Anschlussblock (32) angeordnet sind, entfernt sind,
eines des ersten Halbleiterelements (21) und des dritten Halbleiterelements (23) näher am Anschlussblock (31) als das andere angeordnet ist und eines des zweiten Halbleiterelements (22) und des vierten Halbleiterelements (24) näher am zweiten Anschlussblock (32) als das andere angeordnet ist,
**dadurch gekennzeichnet, dass**
der erste Strompfad (41) länger ist als der zweite Strompfad (42),
der erste Strompfad (41) eine erste Strombehinderungsregion (51 51C) beinhaltet, die zwischen dem ersten Halbleiterelement (21) und dem zweiten Halbleiterelement (22) angeordnet ist, wobei die erste Strombehinderungsregion (51 51C) dazu ausgelegt ist, einen Stromfluss zu behindern,
der zweite Strompfad (42) eine zweite Strombehinderungsregion (52 52C) beinhaltet, die zwischen dem dritten Halbleiterelement (23) und dem vierten Halbleiterelement (24) angeordnet ist, wobei die erste Strombehinderungsregion (52 52C) dazu ausgelegt ist, einen Stromfluss zu behindern, und
ein zweiter elektrischer Widerstand (52R) der zweiten Strombehinderungsregion (52 52C) höher ist als ein erster elektrischer Widerstand (51R) der ersten Strombehinderungsregion (51 51C).

2. Energieversorgungsvorrichtung (100) nach Anspruch 1, wobei
die erste Strombehinderungsregion (51 51C) und die zweite Strombehinderungsregion (52 52C) eine Vielzahl von Wärmedurchkontaktierungen (60 60B 60C 60D) beinhalten, die als in der Leiterplatte (30) bereitgestellte Durchgangslöcher ausgelegt sind und durch die Leiterplatte (30) verlaufen, und
eine Anzahl der Wärmedurchkontaktierungen (60 60B 60C 60D) der zweiten Strombehinderungsregion (52 52C) größer ist als eine Anzahl der Wärmedurchkontaktierungen (60 60B 60C 60D) der zweiten Strombehinderungsregion (51 51C).

3. Energieversorgungsvorrichtung (100) nach Anspruch 1 oder 2, wobei
die Vielzahl von Halbleiterelementen (20) ferner Folgendes beinhalten:
ein fünftes Halbleiterelement (25), das auf einer Seite des ersten Anschlussblocks (31) angeordnet ist; und
ein sechstes Halbleiterelement (26), das auf einer Seite des zweiten Anschlussblocks (32) angeordnet ist,
wobei das fünfte Halbleiterelement (25) und das sechste Halbleiterelement (26) parallel mit dem ersten Halbleiterelement (21) und dem zweiten Halbleiterelement (22) verbunden sind,
wobei das fünfte Halbleiterelement (25) und das sechste Halbleiterelement (26) in Reihe miteinander verbunden sind und einen dritten Strompfad (43) bilden, der sich vom ersten Anschlussblock (31) zum zweiten Anschlussblock (32) erstreckt,
der dritte Strompfad (43) länger ist als der zweite Strompfad (42),
der dritte Strompfad (43) eine dritte Strombehinderungsregion (53 53C) beinhaltet, die dazu ausgelegt ist, einen Stromfluss zu behindern, und
ein dritter elektrischer Widerstand (53R) der dritten Strombehinderungsregion (53 53C) gleich dem ersten elektrischen Widerstand (51R) der ersten Strombehinderungsregion (51 51C) ist.

4. Energieversorgungsvorrichtung (100) nach Anspruch 3, wobei
die dritte Strombehinderungsregion (53 53C) eine Vielzahl von Wärmedurchkontaktierungen (60 60B 60C 60D) beinhaltet, die durch die Leiterplatte (30) verlaufen, und
eine Anzahl der Wärmedurchkontaktierungen (60 60B 60C 60D) der dritten Strombehinderungsregion (53 53C) gleich der Anzahl von Wärmedurchkontaktierungen (60 60B 60C 60D) der ersten Strombehinderungsregion (51 51C) ist.

5. Energieversorgungsvorrichtung (100) nach einem der Ansprüche 1 bis 4, wobei
die Vielzahl von Halbleiterelementen (20) ferner Folgendes beinhalten:
ein siebtes Halbleiterelement (27), das auf einer Seite des ersten Anschlussblocks (31) angeordnet ist; und
ein achtes Halbleiterelement (28), das auf einer Seite des zweiten Anschlussblocks (32) angeordnet ist,
wobei das siebte Halbleiterelement (27) und das achte Halbleiterelement (28) parallel mit dem ersten Halbleiterelement (21) und dem zweiten Halbleiterelement (22) verbunden sind,
wobei das siebte Halbleiterelement (27) und das achte Halbleiterelement (28) in Reihe miteinander verbunden sind und einen vierten Strompfad (44) bilden, der sich vom ersten Anschlussblock (31) zum zweiten Anschlussblock (32) erstreckt,
der vierte Strompfad (44) in der Länge des zweiten Strompfads (42) gleich ist,
der vierte Strompfad (44) eine vierte Strombehinderungsregion (54 54C) beinhaltet, die dazu ausgelegt ist, einen Stromfluss zu behindern, und
ein vierter elektrischer Widerstand (54R) der vierten Strombehinderungsregion (54 54C) gleich dem zweiten elektrischen Widerstand (52R) der zweiten Strombehinderungsregion (52 52C) ist.

6. Energieversorgungsvorrichtung (100) nach Anspruch 5, wobei
die vierte Strombehinderungsregion (54 54C) eine Vielzahl von Wärmedurchkontaktierungen (60 60B 60C 60D) beinhaltet, die durch die Leiterplatte (30) verlaufen, und
die Anzahl der Wärmedurchkontaktierungen (60 60B 60C 60D) der vierten Strombehinderungsregion (54 54C) gleich der Anzahl von Wärmedurchkontaktierungen (60 60B 60C 60D) der zweiten Strombehinderungsregion (52 52C) ist.

7. Energieversorgungsvorrichtung (100) nach Anspruch 1, wobei
die erste Strombehinderungsregion (51 51C) und die zweite Strombehinderungsregion (52 52C) eine Vielzahl von Wärmedurchkontaktierungen (60 60B 60C 60D) beinhalten, die durch die Leiterplatte (30) verlaufen, und
elektrische Widerstände der ersten Strombehinderungsregion (51 51C) und der zweiten Strombehinderungsregion (52 52C) auf Basis von Bereichen von Öffnungen der Wärmedurchkontaktierungen (60 60B 60C 60D) bestimmt werden.

8. Energieversorgungsvorrichtung (100) nach einem der Ansprüche 1 bis 7, wobei
das erste Halbleiterelement (21) und das dritte Halbleiterelement (23) nah beieinander angeordnet sind, und
das zweite Halbleiterelement (22) und das vierte Halbleiterelement (24) nah beieinander angeordnet sind.

9. Energieversorgungsvorrichtung (100) nach einem der Ansprüche 1 bis 8, wobei der erste Anschlussblock (31) und der zweite Anschlussblock (32) Durchgangslöcher sind.

10. Energieversorgungsvorrichtung (100) nach einem der Ansprüche 1 bis 9, wobei die Vielzahl von Halbleiterelementen (20) Feldeffekttransistoren sind.

11. Energieversorgungsvorrichtung (100) nach Anspruch 10, wobei
ein Sourceanschluss (S) von einem Feldeffekttransistor von Feldeffekttransistoren, die das erste Halbleiterelement (21) und das dritte Halbleiterelement (23) bilden, dem ersten Anschlussblock (31) näher ist als ein Sourceanschluss (S) eines anderen [Feld]effekttransistors der Feldeffekttransistoren, und
der eine Feldeffekttransistor dem ersten Anschlussblock (31) näher ist als der andere [Feld]effekttransistor.

12. Energieversorgungsvorrichtung (100) nach Anspruch 10, wobei
ein Sourceanschluss (S) von einem Feldeffekttransistor von Feldeffekttransistoren, die das zweite Halbleiterelement (22) und das vierte Halbleiterelement (24) bilden, dem zweiten Anschlussblock (32) näher ist als ein Sourceanschluss (S) eines anderen [Feld]effekttransistors der Feldeffekttransistoren, und
der eine Feldeffekttransistor dem zweiten Anschlussblock (32) näher ist als ein anderer [Feld]effekttransistor.

## Revendications

1. Dispositif d'alimentation électrique (100) comprenant :
une pluralité de cellules de batterie secondaire (10) ;
une pluralité d'éléments semi-conducteurs (20) connectés à la pluralité de cellules de batterie secondaire (10) ; et
une carte de circuit (30) sur laquelle la pluralité d'éléments semi-conducteurs (20) sont montés, la carte de circuit (30) comportant un premier bornier (31) et un deuxième bornier (32) situé loin du premier bornier (31), le premier bornier (31) connectant électriquement la pluralité d'éléments semi-conducteurs (20) à la pluralité de cellules de batterie secondaire (10), dans lequel :
la pluralité d'éléments semi-conducteurs (20) comportent :
un premier élément semi-conducteur (21) et un troisième élément semi-conducteur (23) qui sont disposés sur un côté du premier bornier (31) ; et
un deuxième élément semi-conducteur (22) et un quatrième élément semi-conducteur (24) qui sont disposés sur un côté du deuxième bornier (32),
le premier élément semi-conducteur (21) et le deuxième élément semi-conducteur (22) sont connectés en parallèle au troisième élément semi-conducteur (23) et au quatrième élément semi-conducteur (24),
le premier élément semi-conducteur (21) et le deuxième élément semi-conducteur (22) sont connectés en série l'un à l'autre et constituent un premier chemin de courant (41) s'étendant du premier bornier (31) au deuxième bornier (32),
le troisième élément semi-conducteur (23) et le quatrième élément semi-conducteur (24) sont connectés en série l'un à l'autre et constituent un deuxième chemin de courant (42) s'étendant du premier bornier (31) au deuxième bornier (32),
le premier chemin de courant (41) est connecté en parallèle au deuxième chemin de courant (42) au niveau du premier bornier (31) et du deuxième bornier (32),
le premier bornier (31) et le deuxième bornier (32) sont des ports d'entrée et de sortie de courant montés sur la carte de circuit (30) et configurés pour permettre la circulation du courant du premier bornier (31) au deuxième bornier (32) ou du deuxième bornier (32) au premier bornier (31) sur la carte de circuit (30),
le premier élément semi-conducteur (21) et le troisième élément semi-conducteur (23) qui sont disposés sur un côté du premier bornier (31) sur la carte de circuit (30) sont séparés du deuxième élément semi-conducteur (22) et du quatrième élément semi-conducteur (24) qui sont disposés sur un côté du deuxième bornier (32),
un parmi le premier élément semi-conducteur (21) et le troisième élément semi-conducteur (23) est disposé plus près du premier bornier (31) que l'autre, et un parmi le deuxième élément semi-conducteur (22) et le quatrième élément semi-conducteur (24) est disposé plus près du deuxième bornier (32) que l'autre,
**caractérisé en ce que**
le premier chemin de courant (41) est plus long que le deuxième chemin de courant (42),
le premier chemin de courant (41) comporte une première région d'obstruction de courant (51 51C) disposée entre le premier élément semi-conducteur (21) et le deuxième élément semi-conducteur (22), la première région d'obstruction de courant (51 51C) étant configurée pour entraver un flux de courant,
le deuxième chemin de courant (42) comporte une deuxième région d'obstruction de courant (52 52C) disposée entre le troisième élément semi-conducteur (23) et le quatrième élément semi-conducteur (24), la deuxième région d'obstruction de courant (52 52C) étant configurée pour entraver un flux de courant, et
une deuxième résistance électrique (52R) de la deuxième région d'obstruction de courant (52 52C) est supérieure à une première résistance électrique (51R) de la première région d'obstruction de courant (51 51C).

2. Dispositif d'alimentation électrique (100) selon la revendication 1, dans lequel
la première région d'obstruction de courant (51 51C) et la deuxième région d'obstruction de courant (52 52C) comportent une pluralité de trous d'interconnexion thermiques (60 60B 60C 60D), configurés comme des trous traversants prévus dans la carte de circuit (30) imprimé et traversant la carte de circuit (30), et
un nombre de trous d'interconnexion thermiques (60 60B 60C 60D) de la deuxième région d'obstruction de courant (52 52C) est supérieur à un nombre de trous d'interconnexion thermiques (60 60B 60C 60D) de la première région d'obstruction de courant (51 51C).

3. Dispositif d'alimentation électrique (100) selon la revendication 1 ou 2, dans lequel
la pluralité d'éléments semi-conducteurs (20) comportent en outre :
un cinquième élément semi-conducteur (25) disposé sur un côté du premier bornier (31) ; et
un sixième élément semi-conducteur (26) disposé sur un côté du deuxième bornier (32),
le cinquième élément semi-conducteur (25) et le sixième élément semi-conducteur (26) sont connectés en parallèle au premier élément semi-conducteur (21) et au deuxième élément semi-conducteur (22),
le cinquième élément semi-conducteur (25) et le sixième élément semi-conducteur (26) sont connectés en série l'un à l'autre et constituent un troisième chemin de courant (43) s'étendant du premier bornier (31) au deuxième bornier (32),
le troisième chemin de courant (43) est plus long que le deuxième chemin de courant (42),
le troisième chemin de courant (43) comporte une troisième région d'obstruction de courant (53 53C) configurée pour entraver un flux de courant, et
une troisième résistance électrique (53R) de la troisième région d'obstruction de courant (53 53C) est égale à la première résistance électrique (51R) de la première région d'obstruction de courant (51 51C).

4. Dispositif d'alimentation électrique (100) selon la revendication 3, dans lequel
le troisième région d'obstruction de courant (53 53C) comporte une pluralité de trous d'interconnexion thermiques (60 60B 60C 60D) traversant la carte de circuit (30), et
un nombre de trous d'interconnexion thermiques (60 60B 60C 60D) de la troisième région d'obstruction de courant (53 53C) est égal au nombre de trous d'interconnexion thermiques (60 60B 60C 60D) de la première région d'obstruction de courant (51 51C).

5. Dispositif d'alimentation électrique (100) selon l'une des revendications 1 à 4, dans lequel
la pluralité d'éléments semi-conducteurs (20) comportent en outre :
un septième élément semi-conducteur (27) disposé sur un côté du premier bornier (31) ; et
un huitième élément semi-conducteur (28) disposé sur un côté du deuxième bornier (32),
le septième élément semi-conducteur (27) et le huitième élément semi-conducteur (28) sont connectés en parallèle au premier élément semi-conducteur (21) et au deuxième élément semi-conducteur (22),
le septième élément semi-conducteur (27) et le huitième élément semi-conducteur (28) sont connectés en série l'un à l'autre et constituent un quatrième chemin de courant (44) s'étendant du premier bornier (31) au deuxième bornier (32),
le quatrième chemin de courant (44) est de longueur égale au deuxième chemin de courant (42),
le quatrième chemin de courant (44) comporte une quatrième région d'obstruction de courant (54 54C) configurée pour entraver un flux de courant, et
une quatrième résistance électrique (54R) de la quatrième région d'obstruction de courant (54 54C) est égale à la deuxième résistance électrique (52R) de la deuxième région d'obstruction de courant (52 52C).

6. Dispositif d'alimentation électrique (100) selon la revendication 5, dans lequel
la quatrième région d'obstruction de courant (54 54C) comporte une pluralité de trous d'interconnexion thermiques (60 60B 60C 60D) traversant la carte de circuit (30), et
le nombre de trous d'interconnexion thermiques (60 60B 60C 60D) de la quatrième région d'obstruction de courant (54 54C) est égal au nombre de trous d'interconnexion thermiques (60 60B 60C 60D) de la deuxième région d'obstruction de courant (52 52C).

7. Dispositif d'alimentation électrique (100) selon la revendication 1, dans lequel
la première région d'obstruction de courant (51 51C) et la deuxième région d'obstruction de courant (52 52C) comportent une pluralité de trous d'interconnexion thermiques (60 60B 60C 60D) traversant la carte de circuit (30), et
les résistances électriques de la première région d'obstruction de courant (51 51C) et de la deuxième région d'obstruction de courant (52 52C) sont déterminées sur la base de zones d'ouverture des trous d'interconnexion thermiques (60 60B 60C 60D).

8. Dispositif d'alimentation électrique (100) selon l'une des revendications 1 à 7, dans lequel
le premier élément semi-conducteur (21) et le troisième élément semi-conducteur (23) sont disposés à proximité l'un de l'autre, et
le deuxième élément semi-conducteur (22) et le quatrième élément semi-conducteur (24) sont disposés à proximité l'un de l'autre.

9. Dispositif d'alimentation électrique (100) selon l'une des revendications 1 à 8, dans lequel le premier bornier (31) et le deuxième bornier (32) sont des trous traversants.

10. Dispositif d'alimentation électrique (100) selon l'une des revendications 1 à 9, dans lequel la pluralité d'éléments semi-conducteurs (20) sont des transistors à effet de champ.

11. Dispositif d'alimentation électrique (100) selon la revendication 10, dans lequel
une borne de source (S) d'un transistor à effet de champ parmi les transistors à effet de champ constituant le premier élément semi-conducteur (21) et le troisième élément semi-conducteur (23) est plus proche du premier bornier (31) qu'une borne de source (S) d'un autre transistor à effet de champ des transistors à effet de champ, et
le premier transistor à effet de champ est plus proche du premier bornier (31) que l'autre transistor à effet de champ.

12. Dispositif d'alimentation électrique (100) selon la revendication 10, dans lequel
une borne de source (S) d'un transistor à effet de champ parmi les transistors à effet de champ constituant le deuxième élément semi-conducteur (22) et le quatrième élément semi-conducteur (24) est plus proche du deuxième bornier (32) qu'une borne de source (S) d'un autre transistor à effet de champ parmi les transistors à effet de champ, et
le premier transistor à effet de champ est plus proche du deuxième bornier (32) que l'autre transistor à effet de champ.
